# EUROPEAN PATENT APPLICATION

(11) **EP 2 682 367 A2**
(43) Date of publication of application: **08.01.2014**
(21) Application number: 12753018.6
(22) Date of filing: 02.03.2012
(51) Int. Cl.: C01B 31/02, H01L 21/329, H01L 21/761

(54) **METHOD FOR N-DOPING GRAPHENE**

(30) Priority: 02.03.2011 KR 20110018425
(71) Applicant: Graphene Square Inc., Gangnam-gu Seoul 135-509 (KR)
(72) Inventor: HONG, Byung Hee, Seoul 135-090 (KR); KIM, Eun Seon, Seoul 136-748 (KR)
(74) Representative: Isarpatent
(86) International application number: PCT/KR2012/001589
(87) International publication number: WO 2012/118350

(57) **Abstract**

The present disclosure provides an n-doping method of graphene, including supplying a reaction gas containing a carbon source and heat to a substrate and reacting to grow graphene on the substrate; and n-doping the graphene by a doping solution containing an n-type dopant or a vapor containing an n-type dopant, an n-doped graphene produced by the method, and a device including the n-doped graphene.

## Description

### [Technical Field]

The present disclosure relates to an n-doping method of a graphene by a doping solution containing an n-type dopant or a vapor containing an n-type dopant, an n-doped graphene prepared by the method, and a device using the same.

### [Background Art]

Fullerene, carbon nanotubes, graphene, graphite, and the like are low-dimensional nano-materials composed of carbon atoms. That is, carbon atoms arranged in a hexagonal shape may form zero-dimensional fullerene formed of a ball, may form carbon nanotubes one-dimensionally rolled, may form graphene of a two-dimensional monolayer, and may form graphite three-dimensionally stacked.

In particular, graphene has very stable and excellent electrical, mechanical, and chemical characteristics and is a very excellent conductive material in which electrons can move about 100 times faster than in silicon and current flows about 100 times more than in copper. This was demonstrated through experiments in 2004 when a method of separating graphene from graphite was found. Since then, a great deal of research on this matter has been carried out.

Graphene is made of pure carbons which are relatively light atoms, and, thus, it is very easy to process graphene in a one-dimensional or two-dimensional nano pattern. With this feature, it is possible to control semiconductive-conductive properties and also possible to manufacture various functional devices including sensors and memories using various chemical bonds of carbon.

In order to apply graphene to such various functional devices, a doping process capable of improving electrical characteristics, such as surface resistance, electric charge mobility, etc. of the graphene is needed. Conventionally, in the field of doping of graphene, a lot of research on surface treatment mainly using a p-type dopant has been carried out, and very little is known about n-doped graphene using an n-type dopant as compared with p-doped graphene.

### [Disclosure of the Invention]

### [Problems to Be Solved by the Invention]

In view of the foregoing, an objective of the present disclosure is to provide a method for easily n-doping a large-area graphene through a simple process using a doping solution containing an n-type dopant or a vapor containing an n-type dopant without using an additional doping apparatus such as a gas pipe or a deposition apparatus.

However, problems to be solved by the present disclosure may not be limited to the above-described problems. Although not described herein, other problems to be solved by the present disclosure can be clearly understood by those skilled in the art from the following descriptions.

### [Means for Solving the Problems]

In order to achieve the objective, in accordance with a first aspect of the present disclosure, there is provided an n-doping method of graphene, including supplying a reaction gas containing a carbon source and heat to a substrate and reacting to grow graphene on the substrate; and n-doping the graphene by a doping solution containing an n-type dopant or a vapor containing an n-type dopant.

In accordance with another aspect of the present disclosure, there is provided an n-doped graphene prepared by the above-described method.

In accordance with still another aspect of the present disclosure, there is provided a device including an n-doped graphene prepared by the above-described method. The device may include, but may not be limited to, a p-n junction diode.

### [Effect of the Invention]

According to the present disclosure, it is possible to easily dope a large-area graphene through a simple process using an amine compound or a reducing material as an n-type dopant and using a doping solution or a vapor containing the n-type dopant without using an additional apparatus. An n-doped graphene can be improved in electrical characteristics and thus can be applied to various devices, and particularly, can be usefully applied to a p-n junction diode.

### [Brief Description of the Drawings]

Fig. 1 is a schematic diagram of explaining an n-doping method of graphene using a doping solution containing an n-type dopant in accordance with an illustrative embodiment of the present disclosure.
Fig. 2 is a schematic diagram of explaining an n-doping method of graphene using a vapor containing an n-type dopant in accordance with an illustrative embodiment of the present disclosure.
Figs. 3A to 3C are graphs of Raman spectra for an n-doped graphene doped by a dopant NaBH₄ in accordance with an example of the present disclosure.
Figs. 4A to 4C are graphs of Raman spectra for an n-doped graphene doped by a dopant NH₂NH₂ in accordance with an example of the present disclosure.
Fig. 5 is a cross-sectional view of explaining a manufacturing process of a graphene electrode for measuring a Dirac point in accordance with an illustrative embodiment of the present disclosure.
Figs. 6A and 6B are graphs showing a change in a Dirac point of an n-doped graphene in accordance with an example of the present disclosure.
Fig. 7 is a graph showing a XPS (X-ray Photoelectron Spectroscopy) analysis result of an n-doped graphene in accordance with an example of the present disclosure.

### [Best Mode for Carrying out the Invention]

Hereinafter, illustrative embodiments and examples of the present disclosure will be described in detail with reference to the accompanying drawings so that the present disclosure may be readily implemented by those skilled in the art.

However, it is to be noted that the present disclosure may not be limited to the illustrative embodiments and examples but can be embodied in various other ways. In drawings, parts irrelevant to the description are omitted for the simplicity of explanation, and like reference numerals denote like parts through the whole document.

Through the whole document, the term "comprises or includes" and/or "comprising or including" used in the document means that one or more other components, steps, operation and/or existence or addition of elements are not excluded in addition to the described components, steps, operation and/or elements unless context dictates otherwise.

The term "about or approximately" or "substantially" is intended to have meanings close to numerical values or ranges specified with an allowable error and intended to prevent accurate or absolute numerical values disclosed for understanding of the present disclosure from being illegally or unfairly used by any unconscionable third party. Through the whole document, the term "step of" does not mean "step for".

In accordance with an illustrative embodiment, there is provided an n-doping method of graphene, including supplying a reaction gas containing a carbon source and heat to a substrate and reacting to grow graphene on the substrate; and n-doping the graphene by a doping solution containing an n-type dopant or a vapor containing an n-type dopant.

In an illustrative embodiment, the n-doping of the graphene may include, but may not be limited to, dropping the doping solution containing the n-type dopant on the graphene to form a liquid doping layer.

In an illustrative embodiment, the n-doping of the graphene may include, but may not be limited to, installing the graphene grown on the substrate in a reaction chamber and supplying the vapor containing the n-type dopant in the reaction chamber.

In an illustrative embodiment, the n-type dopant may include, but may not be limited to, an amine compound or a reducing agent. The amine compound may be employed without limitation from amine compounds typically used in the art for doping. By way of example, the amine compound may include, but may be not limited to, one selected from the group consisting of ammonia (NH₃), hydrazine (NH₂NH₂), pyridine (C₅H₅N), pyrrole (C₄H₅N), acetonitrile (CH₃CN), triethanolamine, aniline, and combinations thereof. Further, the reducing agent may be employed without limitation from reducing agents typically used in the art for doping. By way of example, the reducing agent may include, but may not be limited to, one selected from the group consisting of NaBH₄, LiAl₄, hydroquinones, and combinations thereof.

In an illustrative embodiment, the substrate may have one or more properties among transparency, flexibility, and extendibility, but may not be limited thereto.

In an illustrative embodiment, the substrate may contain one or more metals or alloys selected from, but not limited to, the group consisting of silicon, Ni, Co, Fe, Pt, Au, Al, Cr, Cu, Mg, Mn, Mo, Rh, Si, Ta, Ti, W, U, V, Zr, brass, bronze, white brass, stainless steel, and Ge.

In an illustrative embodiment, the substrate may further include, but may not be limited to, a catalytic layer. The catalyst may contain one or more metals or alloys selected from, but not limited to, the group consisting of Ni, Co, Fe, Pt, Au, Al, Cr, Cu, Mg, Mn, Mo, Rh, Si, Ta, Ti, W, U, V, Zr, brass, bronze, white brass, stainless steel, and Ge.

In an illustrative embodiment, the graphene may include, but may not be limited to, a single-layered graphene or a multi-layered graphene.

In accordance with another aspect of the present disclosure, there is provided an n-doped graphene prepared by any one of the above-described n-doping methods.

In accordance with still another aspect of the present disclosure, there is provided a device including an n-doped graphene prepared by any one of the above-described n-doping methods of the present disclosure. The device may include various electrical/electronic devices and may include, for example, but not limited to, a p-n junction diode. In an illustrative embodiment, the device may be a p-n junction diode containing an n-doped graphene prepared by any one of the above-described n-doping methods of the present disclosure. In an illustrative embodiment, the p-n junction diode may contain a p-type silicon oxide and the n-doped graphene but may not be limited thereto.

All the above descriptions about the n-doping method of the graphene of the present disclosure can be applied to the n-doped graphene of the present disclosure, and the device and the p-n junction diode containing the n-doped graphene, and redundant descriptions will be omitted for convenience sake.

Hereinafter, an n-doping method, an n-doped graphene prepared by the method, and a device using the same in accordance with an illustrative embodiment of the present disclosure will be explained in detail with reference to the accompanying drawings. However, the present disclosure may not be limited thereto.

In an illustrative embodiment, graphene needs to be grown on a substrate in order to dope the graphene.

A method for forming a graphene on a substrate may be employed without particular limitation from methods typically used in the art for growing a graphene. By way of example, the graphene can be grown by a chemical vapor deposition method. As a non-limited example, the chemical vapor deposition method may include, but may not be limited to, rapid thermal chemical vapor deposition (RTCVD), inductively coupled plasma-chemical vapor deposition (ICP-CVD), low pressure chemical vapor deposition (LPCVD), atmospheric pressure chemical vapor deposition (APCVD), metal organic chemical vapor deposition (MOCVD), or plasma-enhanced chemical vapor deposition (PECVD).

In an illustrative embodiment, the process for growing the graphene can be carried out under atmospheric pressure, low pressure, or vacuum. By way of example, if the process is carried out under atmospheric pressure, helium (He) or the like may be used as a carrier gas, it is possible to minimize damage of the graphene caused by collision with heavy argon (Ar) at a high temperature. Further, if the process is carried out under atmospheric pressure, it is possible to prepare a large-area graphene by a simple process with low costs. Furthermore, if the process is carried out under low pressure or vacuum, hydrogen (H₂) may be used as an atmospheric gas, and if the process is carried out along with an increase in temperature, an oxidized surface of a metal catalyst is reduced, so that a high-quality graphene can be synthesized.

In an illustrative embodiment, a material of the substrate on which the graphene is grown may not be particularly limited and may include, for example, one or more metals or alloys selected from the group consisting of silicon, Ni, Co, Fe, Pt, Au, Al, Cr, Cu, Mg, Mn, Mo, Rh, Si, Ta, Ti, W, U, V, Zr, brass, bronze, white brass, stainless steel, and Ge. If the substrate is made of a metal, the substrate itself can act as a catalyst for forming a graphene layer. However, the substrate does not need to be a metal. By way of example, the substrate may be made of silicon, and a silicon substrate may be oxidized to form a further silicon oxide layer on the silicon substrate in order to form a catalytic layer.

In an illustrative embodiment, a catalytic layer may be further formed on the substrate in order for the graphene to be easily grown. The catalytic layer may not be limited in a material, a thickness, and a shape. By way of example, the catalytic layer may include one or more metals or alloys selected from the group consisting of Ni, Co, Fe, Pt, Au, Al, Cr, Cu, Mg, Mn, Mo, Rh, Si, Ta, Ti, W, U, V, Zr, brass, bronze, white brass, stainless steel, and Ge, and may be formed of a material identical to or different from that of the substrate. Further, the catalytic layer is not limited in a thickness and may be a thin film or a thick film.

In an illustrative embodiment, the graphene prepared by the above-described method may have a large area having a horizontal or longitudinal length in a range of from about 1 mm to about 1000 m in a direction. Further, the graphene may include graphene having a uniform structure with few defects. The graphene prepared by the above-described method may include a single-layered graphene or a multi-layered graphene. As a non-limited example, a thickness of the graphene can be adjusted in a range of from 1 layer to 100 layers.

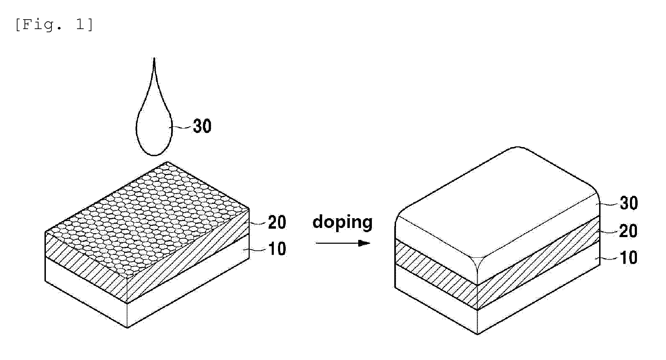

After the graphene is grown on the substrate by the above-described method, a process for n-doping the grown graphene is carried out. Hereinafter, an n-doping method of graphene will be described in detail with reference to Fig. 1.

In an illustrative embodiment, an n-type dopant may be employed without particular limitation from n-type dopants typically used in the art for doping. As a non-limited example, the n-type dopant may include an amine compound or a reducing agent. By way of example, the amine compound may include, but may be not limited to, one selected from the group consisting of ammonia (NH₃), hydrazine (NH₂NH₂), pyridine (C₅H₅N), pyrrole (C₄H₅N), acetonitrile (CH₃CN), triethanolamine, aniline, and combinations thereof. In a structure of the amine compound, nitrogen atoms form a triangular pyramid structure instead of a plane structure and three bonds from a nitrogen atom in the center of the regular tetrahedron head for three vertexes and an electron lone pair is exposed to the outside at the other vertex. The exposed electron lone pair may act as a nucleophile, and the electron lone pair may be shared with the graphene or donated to the graphene so as to be bonded thereto. After all, the graphene that receives the electron may have an n-doping effect.

Further, as the n-type dopant used in an illustrative embodiment may include a reducing agent. The reducing agent is a material that is oxidized and reduces another material, which means that the reducing agent has a strong characteristic of donating its electron to another material. In the present disclosure, an electron of the reducing agent is donated to the graphene so as to n-dope the graphene. As a non-limited example, the reducing agent may include, but may not be limited to, one selected from the group consisting of NaBH₄, LiAl₄, hydroquinones, and combinations thereof. As described above, in the present disclosure, the amine compound having the electron lone pair exposed to the outside or the reducing agent is used as a dopant and an electron of the dopant is donated to the graphene, so that the graphene has a surplus electron and a Fermi level is heightened. Thus, an n-type graphene can be formed.

Fig. 1 is a schematic diagram of explaining an n-doping method of graphene using a doping solution containing an n-type dopant in accordance with an illustrative embodiment of the present disclosure. To be more specific, the graphene can be doped by dropping the doping solution containing the n-type dopant on the graphene to form a liquid doping layer. In an illustrative embodiment, if the dopant is NaBH₄, in order to dissolve the dopant NaBH₄, a solvent such as dimethoxyethylether may be used to prepare a doping solution. The doping solution is dropped in an amount sufficient to cover the graphene by using surface tension with the graphene and the doping time can be adjusted in a range of from several seconds to several minutes depending on a reducing level of the dopant used.

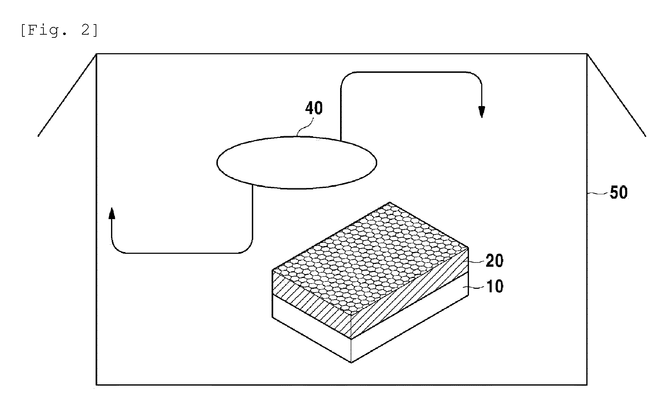

Further, in an illustrative embodiment, it is possible to dope graphene by using an n-type dopant vapor as illustrated in Fig. 2. To be more specific, the graphene can be doped by installing the graphene grown on the substrate in a reaction chamber and supplying the vapor containing the n-type dopant in the reaction chamber. As a non-limited example, the method for doping the graphene using the vapor containing the n-type dopant may include dropping about 3 to 5 drops of an n-type dopant for doping onto tissue paper or gauze and putting it into the sealed reaction chamber together with the graphene. The dopant is vaporized and condensed repeatedly in the sealed reaction chamber to be in a dynamic equilibrium state. During this process, a surface of the graphene can be doped. As compared with a wet doping method using a doping solution, the above-mentioned method using the vapor containing a dopant is an indirect doping method in which the dopant is not in direct contact with the surface of the graphene, and, thus, it is possible to reduce damage of the graphene to be doped.

In order to measure a doping level of the graphene, various methods may be used. By way of example, a change in a Dirac point may be measured by manufacturing a Hall bar device so as to check success or failure of doping and a doping level. By using Raman analysis, a doping level can be qualitatively measured based on intensity and a shift direction of a peak. To be specific, in the case of p-type doping, a 2D-band peak shows a blue shift phenomenon and intensity of the 2D-band peak tends to be weakened. Meanwhile, in the case of n-type doping, a 2D-band peak shows a red shift phenomenon and intensity of the 2D-band peak tends to be weakened. Further, adsorbates on a surface of the graphene can be sorted by using XPS (X-ray Photoelectron Spectroscopy), and it is possible to check a doping level based on a shift direction and intensity of a C1s peak.

In the present disclosure, success or failure of doping of graphene is checked by the above-described various methods. In an example, graphene used in a doping experiment was grown by a chemical vapor deposition method. The grown graphene was transfered onto a SiO₂/Si substrate, and the graphene was doped by a chemical wet method as illustrated in Fig. 1. As a dopant, NaBH₄ dissolved in dimethoxyethylether as a solvent and NH₂NH₂ (hydrazine) were used. The dopant was dropped until the graphene is covered by using surface tension with the graphene and then reacted. The NaBH₄/dimethoxyethylether dopant was used for doping for 2 minutes and the hydrazine dopant was used for doping for 30 seconds.

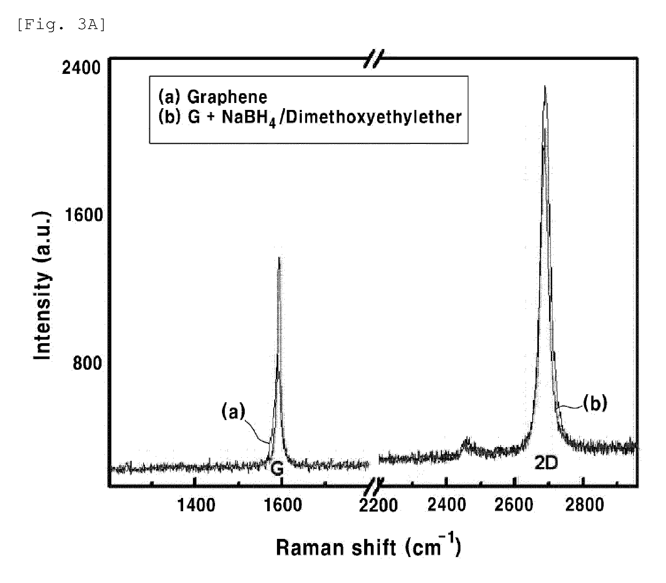

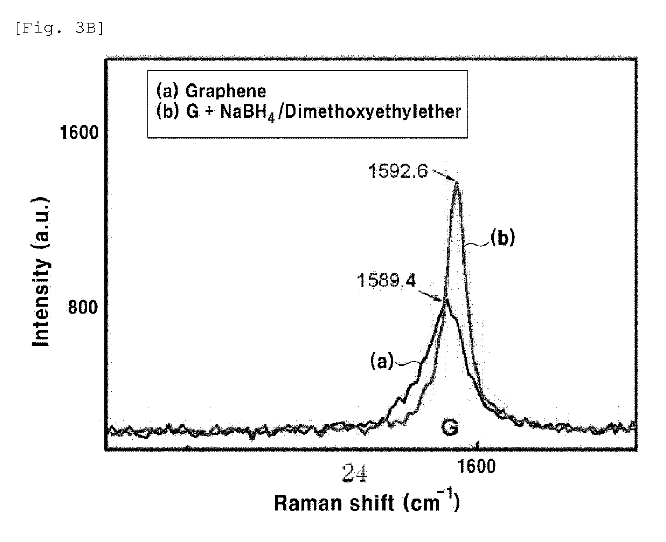

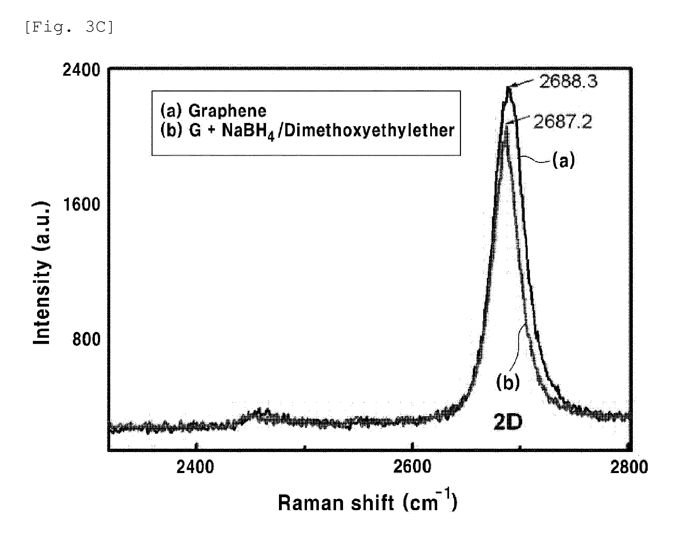

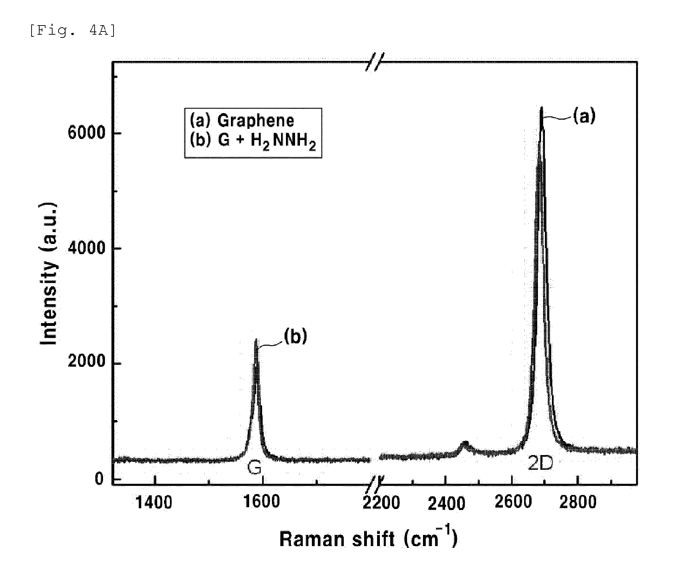

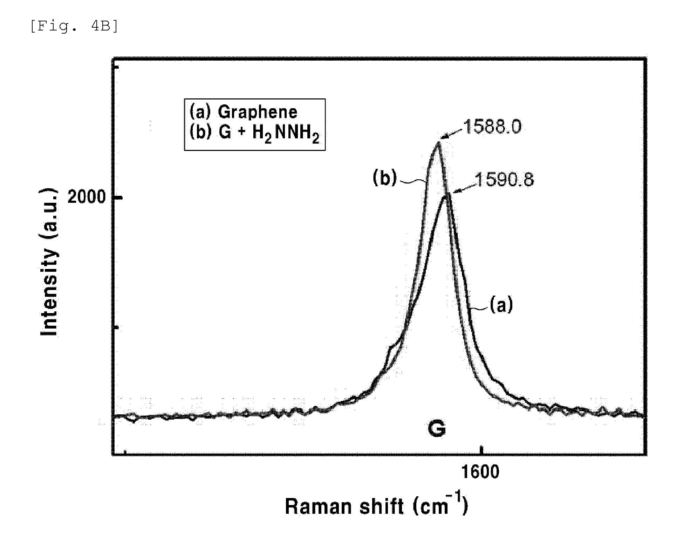

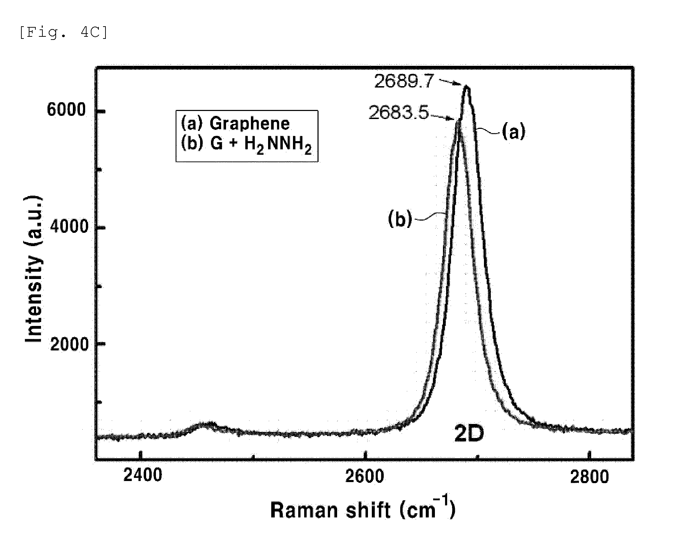

Figs. 3 and 4 are graphs of Raman spectra for an n-doped graphene in accordance with an example of the present disclosure. A G peak commonly found from graphite-based materials is shown at about 1580 cm⁻¹, and a 2D peak is shown at about 2700 cm⁻¹ in graphene. A D peak is a peak caused by defects in a crystal and shown around the edge of a graphene specimen, or if there are many defects, the D peak is shown at about 1340 cm⁻¹. Fig. 3 shows Raman spectra obtained from a Raman monochromator after doping with NaBH₄/dimethoxyethylether in accordance with an example of the present disclosure. After doping, an intensity ratio of a G peak: a 2D peak varied from about 1:2 to about 1:7, and a 2D peak after doping was red-shifted to an energy region lower than a 2D peak of graphene before doping and intensity was slightly decreased (see Fig. 3C). A G peak became sharp and pointed as intensity was increased after doping. As described above, if doping is carried out with electrons or holes, a line width of a G peak becomes decreased and intensity becomes further increased. Referring to Fig. 3 in which as a line width of a G peak became decreased, intensity was increased, and as a line width of a 2D peak became decreased, intensity was decreased, it could be seen that graphene was doped. From a fact that the 2D peak was blue-shifted, it could be further confirmed that the graphene was n-doped.

Fig. 4 shows Raman spectra obtained from a Raman monochromator after doping with hydrazine in accordance with an example of the present disclosure. A 2D peak was red-shifted to a low energy region and intensity was decreased. A G peak was also red-shifted to a low energy region and intensity was increased. From a fact that a spectrum obtained after doping with hydrazine was similar to the Raman spectrum obtained after doping with the NaBH₄/dimethoxyethylether, it could be seen that graphene was n-doped with the hydrazine in the same manner as the NaBH₄/dimethoxyethylether.

As another method for checking success or failure of doping of graphene, a Dirac point shift was measured. A Dirac point is in a graphene band structure where a valence band and a conduction band are in contact with each other, and a Fermi level of a non-doped graphene becomes equal to the Diract point. Since an electron is shifted to graphene during doping, a Diract point is shifted, which makes it possible to analyze success or failure of doping of graphene.

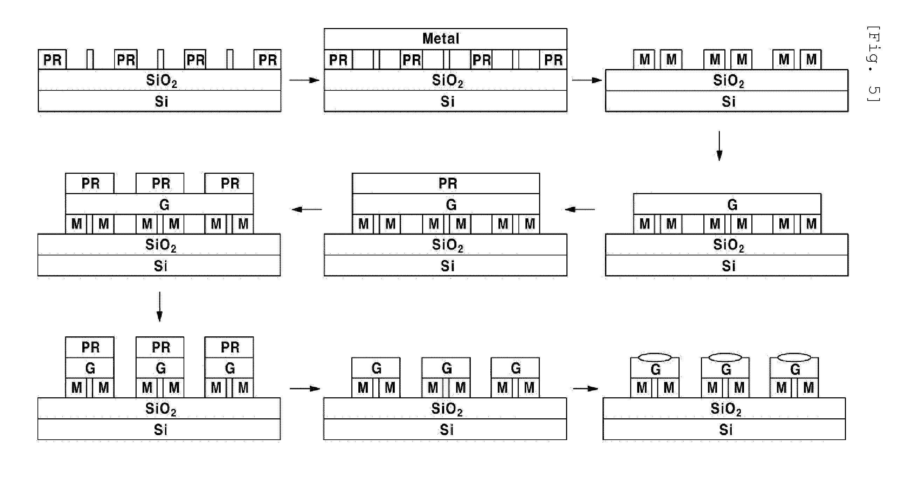

In order to measure a Dirac point, a graphene electrode was manufactured as illustrated in Fig. 5 in accordance with an example of the present disclosure. To be specific, in a manufacturing process of a graphene electrode in accordance with an example of the present disclosure, a photoresist layer was spin-coated on a graphene, and the photoresist layer was etched by photolithography so as to form an electrode pattern, and then, Cr and Au were deposited in sequence on the etched photoresist layer. Then, after lift-off with acetone, the graphene and the photoresist layer were formed in sequence. Thereafter, the photoresist layer was etched by photolithography, and the graphene at the etched portion was etched by a reactive ion etching method using O₂ plasma. Finally, the remaining photoresist layer was removed.

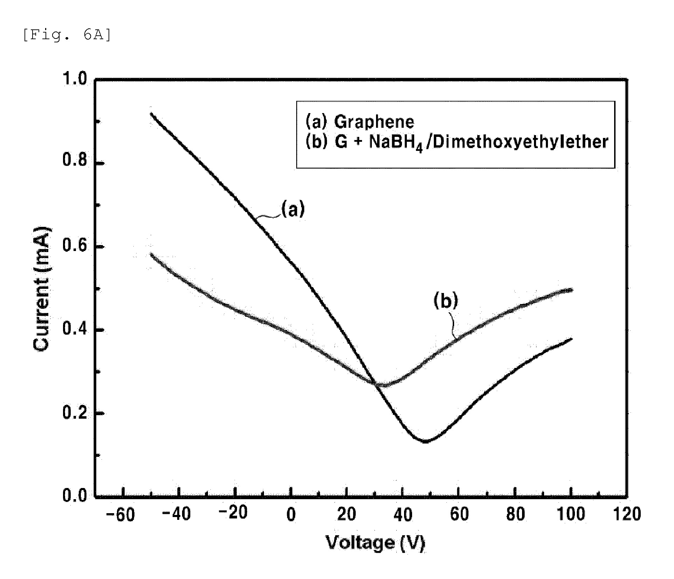

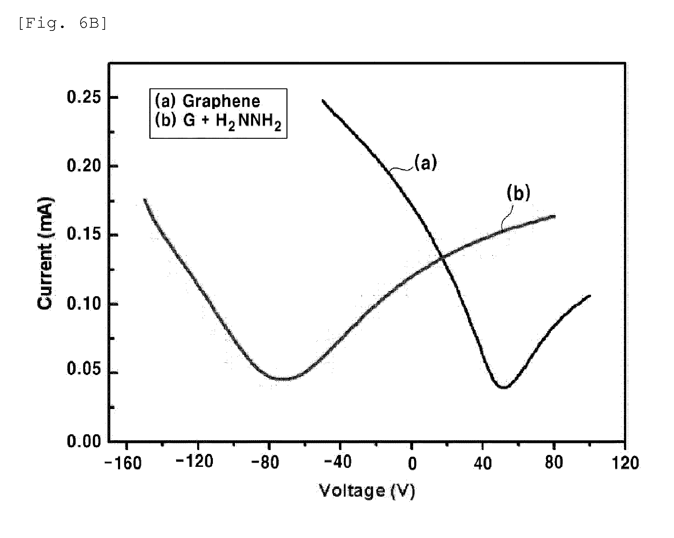

In an example of the present disclosure, referring to Fig. 6A, a Dirac point when the graphene was doped with NaBH₄/dimethoxyethylether was lowered by about 20 V as compared with a Dirac point before the doping. Referring to the positive slope of the graph, it could be seen that electron mobility was rarely changed, and referring to the negative slope, the slope after the doping was decreased, and, thus, hole mobility was decreased. Referring to Fig. 6B, a Dirac point after the graphene was doped with hydrazine was lowered by about 130 V as compared with a Dirac point before the doping. From a fact that the Dirac point was shifted about 7 times than the Dirac point shift when the graphene was doped with NaBH₄/dimethoxyethylether and a Fermi level was further heightened, it could be seen that the n-doping was more carried out when the graphene was doped with the hydrazine dopant as compared with the case where the graphene was doped with the NaBH₄/dimethoxyethylether dopant.

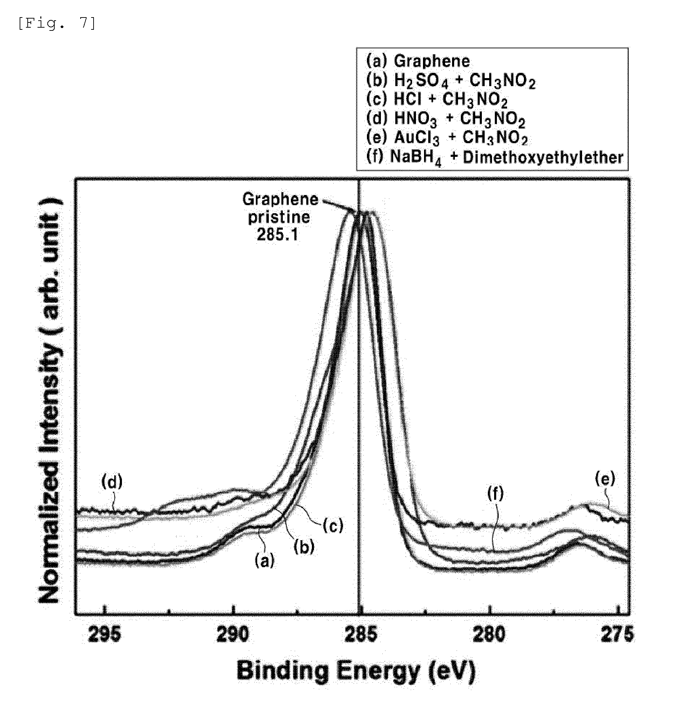

In an example of the present disclosure, as a final method for checking success or failure of doping of graphene, X-ray photoelectron spectroscopy (XPS) was used. Depending on binding energy of carbon atoms in graphene, various dopants were used, and a change in electron binding energy of a C1s orbital function was monitored. As a p-type dopant, H₂SO₄, HCl, HNO₃, and AuCl₃ were used, and as an n-type dopant, NaBH₄/dimethoxyethylether was used, and binding energy was compared. In an example of the present disclosure, as shown in Fig. 7, when a graphene was doped with an acid such as H₂SO₄, HCl, HNO₃, or AuCl₃ as a p-type dopant, binding energy of the doped graphene was lower than binding energy before the doping, and when a graphene was doped with NaBH₄/dimethoxyethylether as an n-type dopant, electron binding energy of the doped graphene was higher than electron binding energy before the doping, which showed that n-doping was carried out.

Although the present invention has been explained with reference to the examples of the present disclosure, it would be understood by those skilled in the art that various changes and modifications may be made within a concept and a scope of the present invention described in the accompanying claims.

## Claims

1. An n-doping method of graphene, comprising:
supplying a reaction gas containing a carbon source and heat to a substrate and reacting to grow graphene on the substrate; and
n-doping the graphene by a doping solution containing an n-type dopant or a vapor containing an n-type dopant.

2. The n-doping method of graphene of claim 1,
wherein the n-doping of the graphene includes dropping the doping solution containing the n-type dopant on the graphene to form a liquid doping layer.

3. The n-doping method of graphene of claim 1,
wherein the n-doping of the graphene includes installing the graphene grown on the substrate in a reaction chamber and supplying the vapor containing the n-type dopant in the reaction chamber.

4. The n-doping method of graphene of claim 1,
wherein the n-type dopant includes an amine compound or a reducing agent.

5. The n-doping method of graphene of claim 4,
wherein the amine compound includes one selected from the group consisting of ammonia (NH₃), hydrazine (NH₂NH₂), pyridine (C₅H₅N), pyrrole (C₄H₅N), acetonitrile (CH₃CN), triethanolamine, aniline, and combinations thereof.

6. The n-doping method of graphene of claim 4,
wherein the reducing agent includes one selected from the group consisting of NaBH₄, LiAl₄, hydroquinones, and combinations thereof.

7. The n-doping method of graphene of claim 1,
wherein the substrate has one or more properties among transparency, flexibility, and extendibility.

8. The n-doping method of graphene of claim 1,
wherein the substrate further includes a catalytic layer.

9. The n-doping method of graphene of claim 1,
wherein the graphene includes a single-layered graphene or a multi-layered graphene.

10. An n-doped graphene prepared by a method of any one of claims 1 to 9.

11. A device comprising an n-doped graphene of claim 10.

12. A p-n junction diode comprising an n-doped graphene of claim 10.
